(19) Europäisches Patentamt
European Patent Office
Office européen des brevets

(11) EP 2 592 659 A1

(12) **EUROPEAN PATENT APPLICATION**
published in accordance with Art. 153(4) EPC

(43) Date of publication:
**15.05.2013 Bulletin 2013/20**

(21) Application number: **11803370.3**

(22) Date of filing: **04.04.2011**

(51) Int Cl.:
***H01L 31/042*** (2006.01) ***C08G 63/85*** (2006.01)
***C08J 5/18*** (2006.01)

(86) International application number:
**PCT/JP2011/058517**

(87) International publication number:
**WO 2012/005034 (12.01.2012 Gazette 2012/02)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **06.07.2010 JP 2010153937**

(71) Applicant: **Teijin Dupont Films Japan Limited**
**Chiyoda-ku**
**Tokyo 100-0013 (JP)**

(72) Inventors:
- **MATSUMURA, Naoko**
  **Anpachi-gun**
  **Gifu 503-0123 (JP)**
- **SHIMIZU, Tomoko**
  **Anpachi-gun**
  **Gifu 503-0123 (JP)**
- **OYAMATSU, Atsushi**
  **Anpachi-gun**
  **Gifu 503-0123 (JP)**

(74) Representative: **Hallybone, Huw George**
**Carpmaels & Ransford**
**One Southampton Row**
**London**
**WC1B 5HA (GB)**

(54) **POLYESTER FILM FOR PROTECTING REAR SURFACE OF SOLAR CELL**

(57) A polyester film for protecting a rear surface of a solar cell is provided, in that the polyester film is suppressed in reduction of mechanical properties on long-term use under a high temperature and high humidity environment. The polyester film for protecting a rear surface of a solar cell, containing a white polyester film layer containing a polyester composition containing 85 to 96% by weight of polyethylene terephthalate that is polymerized with an antimony compound and/or a titanium compound as a polycondensation catalyst and 4 to 15% by weight of rutile type titanium oxide particles, the polyester composition containing, based on the molar number of the total dicarboxylic acid component constituting the polyethylene terephthalate, 10 to 40 millimole % of a particular phosphoric acid compound and 2 to 50 millimole % in total in terms of metal elements of antimony element and/or titanium element derived from the polycondensation catalyst, and the polyester film for protecting a rear surface of a solar cell having an initial delamination strength of 6 N/15 mm or more and an elongation retention rate after aging for 3,000 hours under an environment with a temperature of 85°C and a humidity of 85%RH of 50% or more.

EP 2 592 659 A1

## Description

Technical Field

The present invention relates to a white polyester film for protecting a rear surface of a solar cell, in that the polyester film is excellent in environmental resistance. More specifically, the invention relates to a white polyester film for protecting a rear surface of a solar cell, in that the polyester film is suppressed in reduction of mechanical properties on long-term use under a high temperature and high humidity environment, has excellent delamination resistance, and maintains a good protection function on long-term use.

Background Art

In recent years, a solar electric power generation system using a solar cell module is being widely spread as an electric power generation system using clean energy. The structure of the solar cell module is generally produced by a lamination method as described, for example, in JP-A-2007-129014 (Patent Document 1), in which a transparent front substrate on light receiving side, a filler, a solar cell element, a filler, and a film for protecting a rear surface of a solar cell are laminated in this order and heat-adhered under vacuum.

The rear surface protective film for a solar cell is used for fixing, protecting and electrically insulating a solar cell element, and is strongly demanded to have heat resistance, hydrolysis resistance, UV resistance, hiding power and electric insulating property. Furthermore, the film is also demanded to have dimensional stability at a high temperature for enhancing the working efficiency on producing the module and for maintaining the protection function for a prolonged period of time. The rear surface protective film generally has a structure containing plural films or sheets laminated on each other, and in particular, a structure containing fluorine resin film/polyester film/fluorine resin film is widely employed.

However, the fluorine resin film has drawbacks including poor gas barrier property and poor stiffness although it is excellent in weather resistance, heat resistance and hydrolysis resistance. The fluorine resin film also has problems including an environmental issue depending on the discarding method therefor and a high cost.

Many examples of using a heat resistant polyester film instead of the fluorine resin film have been known. For example, there have been studies on the use of a polyester film containing a component derived from 2,6-naphthalenedicarboxylic acid (JP-A-2007-070885 (Patent Document 2) and JP-A-2006-306910 (Patent Document 3)), the use of a polyethylene terephthalate film having a large molecular weight (JP-A-2002-026354 (Patent Document 4) and WO07/105306 (Patent Document 5)), and the use of a polyethylene terephthalate film having a small oligomer content (JP-A-2002-100788 (Patent Document 6), JP-A-2002-134770 (Patent Document 7) and JP-A-2002-134771 (Patent Document 8)).

However, the polyester film containing a component derived from 2,6-naphthalenedicarboxylic acid suffers large deterioration and decoloration under an ultraviolet ray and is expensive as compared to a polyethylene terephthalate film, and thus the film is restricted in application in this field. The polyethylene terephthalate film having a large molecular weight and the polyethylene terephthalate film having a small oligomer content have a problem in production efficiency although the films are relatively inexpensive and excellent in hydrolysis resistance.

Furthermore, the module is demanded to have an enhanced photoelectric conversion efficiency for solar light, and the use of a white polyester film having a large reflectivity and excellent environmental resistance is being investigated for utilizing the light reflected by the rear surface protective film for the photoelectric conversion. A polyester film that is colored white is poor in hydrolysis resistance, which is the most demanded factor in the environmental resistance, and thus is restricted in application in this field, but as a film having hydrolysis resistance irrespective of the white color thereof, a thermoplastic resin sheet for a solar cell, having a number average molecular weight of 18,500 to 40,000 and containing titanium dioxide in an amount of 5 to 40% by weight over the total layer (JP-A-2006-270025 (Patent Document 9)).

However, when hydrolysis resistance is imparted to a white film only by the method of increasing the molecular weight of the polymer as in Patent Document 9, the polymerization time is prolonged to deteriorate the economical efficiency, and the hydrolysis resistance obtained is still insufficient.

Furthermore, a white polyester film is liable to suffer delamination occurring inside the film, as compared to a transparent film containing no colorant, and the solar cell element is affected by water or the like, which may bring about reduction of the electric power generation capability of the solar cell module.

(Patent Document 1) JP-A-2007-129014
(Patent Document 2) JP-A-2007-0070885
(Patent Document 3) JP-A-2006-306910
(Patent Document 4) JP-A-2002-026354

(Patent Document 5) WO07/10530
(Patent Document 6) JP-A-2002-100788
(Patent Document 7) JP-A-2002-134770
(Patent Document 8) JP-A-2002-134771
(Patent Document 9) JP-A-2006-270025

Disclosure of the Invention

Problems to be solved by the Invention

The invention has been made for solving the aforementioned problems associated with an ordinary film for protecting a rear surface of a solar cell, and is to provide a white polyester film for protecting a rear surface of a solar cell, in that the polyester film is excellent in environmental resistance. Accordingly, an object of the invention is to provide a white polyester film for protecting a rear surface of a solar cell, in that the polyester film is suppressed in reduction of mechanical properties on long-term use under a high temperature and high humidity environment, has excellent delamination resistance, and maintains a good protection function on long-term use.

As a second object of the invention is to provide a white polyester film for protecting a rear surface of a solar cell, in that the polyester film is suppressed in reduction of mechanical properties on long-term use under a high temperature and high humidity environment, has excellent delamination resistance, and maintains a good protection function on long-term use, and in the case where a carbodiimide compound is used as a hydrolysis resistance enhancing agent, the carbodiimide compound is prevented from bleeding, thereby suppressing reduction of the delamination resistance.

Means for solving the Problems

As a result of earnest investigations made by the present inventors for solving the problems, it has been found that the use of a polycondensation catalyst of a particular metal element and a polyester containing a particular phosphoric acid compound in a particular amount provides a polyester having a low terminal carboxyl group concentration without performing polycondensation reaction for a prolonged period of time, and when a white film is formed with the polyester, the film has high crystallinity and high orientation in the thickness direction of the film and is suppressed in reduction of mechanical properties on long-term use under a high temperature and high humidity environment. Simultaneously, it has been also found that excellent delamination resistance is obtained irrespective of the white color of the polyester film, and excellent resistance to the severe natural environment (e.g., heat resistance, hydrolysis resistance and weather resistance). Thus, the invention has been completed.

The objects of the invention is accomplished by a polyester film for protecting a rear surface of a solar cell, the polyester film containing a white polyester film layer containing a polyester composition containing 85 to 96% by weight of polyethylene terephthalate that is polymerized with an antimony compound and/or a titanium compound as a polycondensation catalyst and 4 to 15% by weight of rutile type titanium oxide particles, the polyester composition containing, based on the molar number of the total dicarboxylic acid component constituting the polyethylene terephthalate, 10 to 40 millimole % of a phosphoric acid compound represented by the following general formula (I) or (II):

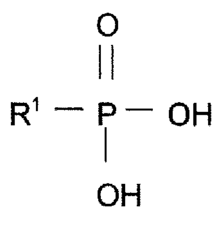

general formula (I)

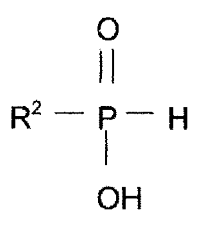

general formula (II)

(wherein $R^1$ and $R^2$ each represent one of an alkyl group which is a hydrocarbon group having 1 to 6 carbon atoms, an

aryl group, and a benzyl group)

and 2 to 50 millimole % in total in terms of metal elements of antimony element and/or titanium element derived from the polycondensation catalyst, and the polyester film for protecting a rear surface of a solar cell having an initial delamination strength of 6 N/15 mm or more and an elongation retention rate after aging for 3,000 hours under an environment with a temperature of 85°C and a humidity of 85%RH of 50% or more (item 1).

The polyester film for protecting a rear surface of a solar cell of the invention includes, as a preferred embodiment, at least one embodiment of the following items 2 to 8.

2. The polyester film for protecting a rear surface of a solar cell according to the item 1, wherein the film has an elongation retention rate after aging for 6,000 hours under an environment with a temperature of 130°C of 40% or more.
3. The polyester film for protecting a rear surface of a solar cell according to the item 1 or 2, wherein the film has a delamination strength after aging for 3,000 hours under an environment with a temperature of 85°C and a humidity of 85%RH of 4 N/15 mm or more.
4. The polyester film for protecting a rear surface of a solar cell according to any one of the items 1 to 3, wherein the phosphoric acid compound is phenylphosphonic acid or phenylphosphinic acid.
5. The polyester film for protecting a rear surface of a solar cell according to any one of the items 1 to 4, wherein the polyethylene terephthalate constituting the white polyester film layer has a terminal carboxyl group concentration of 6 to 20 eq/ton.
6. The polyester film for protecting a rear surface of a solar cell according to any one of the items 1 to 5, wherein the polyethylene terephthalate constituting the white polyester film layer has a weight average molecular weight of 44,000 to 61,000.
7. The polyester film for protecting a rear surface of a solar cell according to any one of the items 1 to 6, wherein the polyester film is a stretched film having a laminated structure containing a substrate layer having provided on at least one surface thereof a surface layer, and at least one layer thereof is the white polyester film layer.
8. The polyester film for protecting a rear surface of a solar cell according to the item 7, wherein the polyester film is a stretched film having a laminated structure containing a substrate layer having provided on both surfaces thereof surface layers, at least one layer thereof is the white polyester film layer, the surface layers are each a layer having a thickness of 3.0 μm or more and containing polyethylene terephthalate containing no carbodiimide compound, the substrate layer contains 0.3 to 2.5 parts by weight of a carbodiimide compound per 100 parts by weight of the polyethylene terephthalate, and the polyester film has an elongation retention rate after aging for 4,000 hours under an environment with a temperature of 85°C and a humidity of 85%RH of 40% or more.

The invention also includes a protective film for a rear surface of a solar cell, containing the polyester film for protecting a rear surface of a solar cell according to any one of the items 1 to 8.

Advantages of the Invention

According to the invention, a white polyester film for protecting a rear surface of a solar cell is provided, in that the polyester film is suppressed in reduction of mechanical properties on long-term use under a high temperature and high humidity environment, has excellent delamination resistance, and maintains a good protection function on long-term use.

Best Mode for carrying out the Invention

The invention will be described in detail below.

The invention relates to a polyester film for protecting a rear surface of a solar cell, containing a white polyester film layer, and the film may be a single layer film or a laminated film in such a range that does not impair the characteristics of the film. In the case of the laminated film, a laminated film formed by co-extrusion is preferred from the standpoint of the productivity.

In the case of the laminated film, specific examples of the structure thereof include a stretched film having a laminated structure containing a substrate layer having provided on at least one surface thereof a surface layer, in which at least one layer thereof is the white polyester film layer. Examples thereof also include a stretched film having a laminated structure containing a substrate layer having provided on both surfaces thereof surface layers, in which at least one layer thereof is the white polyester film layer. Among the laminated structures, a two-layer structure having the surface layer provided on one surface of the substrate layer and a three-layer structure having the surface layers provided on both surfaces of the substrate layer are preferred.

Polyethylene Terephthalate

The polyethylene terephthalate constituting the polyester film of the invention is a polyester containing ethylene terephthalate as a major repeating unit, and thus is a polyester containing terephthalic acid or a derivative thereof as a dicarboxylic acid component and ethylene glycol as a diol component. The major repeating unit herein is a repeating unit that occupies 90% by mol or more, preferably 95% by mol or more, and further preferably 97% by mol or more, of the total repeating units constituting the polyester.
The polyethylene terephthalate of the invention may be copolymerized with another component in such a range that does not impair the advantages of the invention, and the copolymerized component may be an acid component or an alcohol component. Examples of the copolymerized dicarboxylic acid component include an aromatic dicarboxylic acid, such as isophthalic acid, phthalic acid and naphthalenedicarboxylic acid, an aliphatic dicarboxylic acid, such as adipic acid, azelaic acid, sebacic acid and decanedicarboxylic acid, and an alicyclic dicarboxylic acid, such as cyclohexanedicarboxylic acid. Examples of the copolymerized diol component include an aliphatic diol, such as butanediol and hexanediol, and an alicyclic diol, such as cyclohexanedimethanol. These compounds may be used solely or as a combination of two or more kinds thereof.
In the case where the copolymerized amount of the aforementioned dicarboxylic acid component and/or diol component exceeds 10% by mol, the delamination resistance may be enhanced, but the crystallinity may be lowered, which brings about deterioration of the heat resistance and the hydrolysis resistance, and also the thermal contraction rate may be increased.
The polyethylene terephthalate constituting the polyester film of the invention is polyethylene terephthalate that is polymerized with an antimony compound and/or a titanium compound as a polycondensation catalyst. In the case where polyethylene terephthalate is formed by polycondensation by using a certain amount of the compounds as a polycondensation catalyst, and further using a certain amount of the phosphoric acid compound of the invention, under a certain production condition, such polyethylene terephthalate that has the limiting viscosity number and the terminal carboxyl group concentration, which are described later, may be obtained efficiently, without performing polycondensation reaction for a prolonged period of time as in a conventional case.
The limiting viscosity number of the polyethylene terephthalate is preferably 0.62 to 0.90 dL/g, more preferably 0.65 to 0.85 dL/g, and particularly preferably 0.67 to 0.85 dL/g. When the limiting viscosity number is in the range, the weight average molecular weight of the polyester of the film may be controlled to a range of 44,000 to 61,000, thereby providing the polyethylene terephthalate that is excellent in heat resistance, hydrolysis resistance and delamination resistance, and is easily melt-extruded on forming the film. The limiting viscosity number of the polyethylene terephthalate is a value obtained from a measured value at 35°C after dissolving in a mixed solvent of phenol and tetrachloroethane at a weight ratio of 6/4.

Phosphoric Acid Compound

The polyester composition constituting the white polyester film layer in the invention necessarily contains, based on the molar number of the total dicarboxylic acid component constituting the polyethylene terephthalate, a phosphoric acid compound represented by the following general formula (I) or (II) in a proportion of 10 to 40 millimole %, preferably 10 to 30 millimole %, and further preferably 10 to 20 millimole %. The phosphoric acid compound in the invention means a phosphoric acid compound as a generic term.
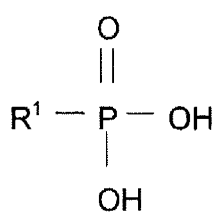

general formula (I)

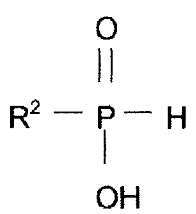

general formula (II)

(wherein $R^1$ and $R^2$ each represent one of an alkyl group which is a hydrocarbon group having 1 to 6 carbon atoms, an aryl group, and a benzyl group).

When the content of the phosphoric acid compound is smaller than the lower limit, the resulting polyester film is insufficient in crystallinity and thus fails to provide sufficient heat resistance and hydrolysis resistance. When the phosphoric acid compound is used in an amount exceeding the upper limit, the advantages obtained thereby is saturated, which is uneconomical, and furthermore there is a tendency of reducing the hydrolysis resistance. The white film containing rutile type titanium oxide particles has a larger crystallization speed in a cooling process after melting than the case without the addition of rutile type titanium oxide particles. Accordingly, when the amount of the phosphoric acid compound is contained excessively exceeding the upper limit to increase further the crystallization speed, crystallization may proceed in cooling and solidification process on a casting drum on forming the film, which may cause cracking on stretching.

Preferred examples of the phosphoric acid compound include phenylphosphonic acid and phenylphosphinic acid. The use of a phosphoric acid compound such as phenylphosphonic acid can make the polycondensation reaction to proceed efficiently even at a low temperature. Accordingly, polyethylene terephthalate having a high molecular weight and a small terminal carboxyl group concentration may be obtained without performing polycondensation reaction for a prolonged period of time as in a conventional case or without using a hydrolysis resistance enhancing agent, such as an epoxy compound, that reacts with a terminal functional group of polyester, in the solid phase polymerization.

The phosphoric acid compound may be added in an arbitrary step in the polymerization of the polyethylene terephthalate.

In the case where the polyester film for protecting a rear surface of a solar cell of the invention is a laminated film, it is necessary that at least the polyester composition constituting the white polyester film layer contains the phosphoric acid compound in the aforementioned amount, it is preferred that the total polyester composition over the laminated film contains the phosphoric acid compound in the aforementioned amount, and it is more preferred that all the polyethylene terephthalates of the layers of the laminated film each contain the phosphoric acid compound in the aforementioned amount.

Metal Element

The polyester film for protecting a rear surface of a solar cell of the invention contains the phosphoric acid compound mentioned above and antimony element derived from the antimony compound used as the polycondensation catalyst and/or titanium element derived from the titanium compound used as the polycondensation catalyst, and thereby such polyethylene terephthalate that has the limiting viscosity number and the terminal carboxyl group concentration, which are described later, may be obtained efficiently, without performing polycondensation reaction for a prolonged period of time as in a conventional case, and furthermore the crystallinity of the film is enhanced to provide high heat resistance, hydrolysis resistance and dimensional stability.

The polyester composition constituting the white polyester film layer in the invention contains antimony element and/or titanium element derived from the polycondensation catalyst in an amount of 2 to 50 millimole %, preferably 10 to 40 millimole %, and further preferably 15 to 30 millimole %, in total in terms of metal elements, based on the molar number of the total dicarboxylic acid component constituting the polyethylene terephthalate.

When the total content of antimony element and/or titanium element derived from the polycondensation catalyst is smaller than the lower limit, the polycondensation reaction speed is too small, and thus not only the productivity of the polyester raw materials is lowered, but also a crystalline polyester having the necessary limiting viscosity number is not obtained, thereby failing to provide a film having sufficient heat resistance and hydrolysis resistance. When the total content of antimony element and/or titanium element exceeds the upper limit, an excessive amount of the polycondensation catalyst is present in the film, which deteriorates the heat resistance and the hydrolysis resistance of the film, or largely colors the film. The amount of the polycondensation catalyst is preferably suppressed as small as possible in consideration of the balance between the productivity and the polymerization degree.

Examples of the antimony compound include an organic antimony compound, such as antimony oxide, antimony chloride and antimony acetate, and antimony oxide or antimony acetate is preferably used. The antimony compound may be used solely or as a combination of plural kinds thereof.

Examples of the titanium compound derived from the polycondensation catalyst include a titanium compound that is ordinarily used as a polycondensation catalyst of a polyester, for example, titanium acetate and tetra-n-butoxytitanium.

In the polycondensation catalysts, an antimony compound and a titanium compound are preferably used in combination. In the case where these polycondensation catalysts are used in combination, the content of antimony element is preferably 50% by mol or more, more preferably 60% by mol or more, and particularly preferably 70% by mol or more, of the total amount thereof.

In the case where the polyester film for protecting a rear surface of a solar cell of the invention is a laminated film, it is necessary that at least the polyester composition constituting the white polyester film layer contains the metal

elements in the aforementioned amount, it is preferred that the total polyethylene terephthalate over the laminated film contains the metal elements in the aforementioned amount, and it is more preferred that all the polyethylene terephthalates of the layers of the laminated film each contain the metal elements in the aforementioned amount.

Rutile type Titanium Oxide Particles

The polyester composition constituting the white polyester film layer in the invention contains rutile type titanium oxide particles. The crystal forms of titanium oxide include rutile type and anatase type, and in the invention, the use of rutile type titanium oxide suppresses degradation of the film due to an ultraviolet ray, thereby suppressing discoloration and diminish of the mechanical strength of the film on irradiation of light for a long period of time.

The average particle diameter of the rutile type titanium oxide particles is preferably 0.1 to 5.0 μm, and particularly preferably 0.1 to 3.0 μm. By using the particles having an average particle diameter within the range, the rutile type titanium oxide particles may be dispersed in polyethylene terephthalate in a favorable dispersed state to provide a uniform film without aggregation of the particles, and simultaneously, a film having good stretchability may be produced.

The method of adding and dispersing the rutile type titanium oxide particles in polyethylene terephthalate to prepare a polyester composition containing the rutile type titanium oxide particles may be various known methods, and representative examples of the methods include the following methods.

(a) The rutile type titanium oxide particles are added before completing the ester exchange reaction or the esterification reaction on synthesizing the polyethylene terephthalate, or the rutile type titanium oxide particles are added before starting the polycondensation reaction.
(b) The rutile type titanium oxide particles are added to the polyethylene terephthalate, which is then melt-kneaded.
(c) Master pellets containing a large amount of the rutile type titanium oxide particles are produced by the method (a) or (b), and then mixed and kneaded with polyethylene terephthalate containing no rutile type titanium oxide particle, and thereby a prescribed amount of the rutile type titanium oxide particles are contained therein.
(d) The master pellets in the method (c) are used as they are.

In the case where the polyester film for protecting a rear surface of a solar cell of the invention is a single layer film, the polyester film for protecting a rear surface of a solar cell is formed of a polyester composition containing 85 to 96% by weight of polyethylene terephthalate that is polymerized with an antimony compound and/or a titanium compound as a polycondensation catalyst and 4 to 15% by weight of rutile type titanium oxide particles. Accordingly, the polyester composition in the invention contains rutile type titanium oxide particles in an amount of 4 to 15% by weight, and preferably 4 to 10% by weight, based on 100% by weight of the polyester composition.

When the content of the rutile type titanium oxide particles is smaller than the lower limit, light reflected from the polyester film used as a rear surface protective film for a solar cell may not be effectively subjected to photoelectric conversion, and it may be insufficient to suppress degradation of the film due to an ultraviolet ray. When the content of the rutile type titanium oxide particles exceeds the upper limit, such problems may occur that the film is liable to suffer delamination, the film is deteriorated in heat resistance and hydrolysis resistance, the strength of the film is lowered to cause breakage, which deteriorates the productivity.

In the case where the polyester film for protecting a rear surface of a solar cell of the invention is a laminated film, the polyester film for protecting a rear surface of a solar cell preferably contains at least one white polyester film layer that is formed of a polyester composition containing 85 to 96% by weight of polyethylene terephthalate that is polymerized with an antimony compound and/or a titanium compound as a polycondensation catalyst and 4 to 15% by weight of rutile type titanium oxide particles.

In the case of a three-layer structure containing a substrate layer having formed on both surfaces thereof surface layers, the white polyester film layer may be the surface layer or the substrate layer. High weather resistance may be obtained by using at least one white polyester layer contained. Simultaneously, when the other layers do not contain the titanium oxide particles, or even though contained, the amount thereof is limited to 2 parts by weight or less per 100 parts by weight of the polyethylene terephthalate constituting the other layers, the polyester film for protecting a rear surface of a solar cell of the invention may be totally enhanced in hydrolysis resistance, and may be prevented from suffering cohesion failure within the layer, thereby enhancing the cohesion failure resistance of the total polyester film.

Hydrolysis Resistance Enhancing Agent

The polyester film for protecting a rear surface of a solar cell of the invention has sufficient hydrolysis resistance without the use of a hydrolysis resistance enhancing agent, but a hydrolysis resistance enhancing agent may be added for further enhancing the hydrolysis resistance. Examples of the hydrolysis resistance enhancing agent include an oxazoline compound and a carbodiimide compound.

In the case where a carbodiimide compound is used as the hydrolysis resistance enhancing agent, preferred examples thereof include a biscarbodiimide and an aromatic polycarbodiimide. Among these, a biscarbodiimide represented by R-N=C=N-R' is preferably used as an example that exhibits a large hydrolysis resistance enhancing capability, in which R and R' each preferably represent a substituted or unsubstituted alkyl group having 4 to 20 carbon atoms and/or an aryl group. When the group represented by R and R' has a substituent, the substituent may be selected from the group consisting of a halogen atom, a nitro group, an amino group, a sulfonyl group, a hydroxyl group and an alkyl or alkoxy group, and R and R' may be the same as or different from each other.

Examples of the aromatic polycarbodiimide include an aromatic polycarbodiimide formed by connecting a carbodiimide represented by R-N=C=N- through an aryl group as R.

Specific examples of the carbodiimide compound include N,N'-diisopropylcarbodiimide, N,N'-di-n-butylcarbodiimide, N,N'-di-n-hexylcarbodiimide, N,N'-dicyclohexylcarbodiimide, N,N'-diphenylcarbodiimide, N,N'-bis(2-methylphenyl)carbodiimide, N,N'-bis(2-ethylphenyl)carbodiimide, N,N'-bis(2-isopropylphenyl)carbodiimide, N,N'-bis(2,6-dimethylphenyl)carbodiimide, N,N'-bis(2,6-diethylphenyl)carbodiimide, N,N'-bis(2,6-diisopropylphenyl)carbodiimide, N,N'-bis (2,6-dimethoxyphenyl)carbodiimide and N,N'-bis(2,4,6-trimethylphenyl)carbodiimide.

Specific examples of the biscarbodiimide include 2,2',6,6'-tetraisopropyldiphenylcarbodiimide, which is produced by Rhein Chemie Rheinau GmbH under a trade name "Stabaxol I". Specific examples of the polycarbodiimide compound include a copolymer of 2,4-diisocyanato-1,3,5-tris(1-methylethyl) and 2,6-diisopropyldiisocyanate, which is produced by Rhein Chemie Rheinau GmbH, Germany, under a trade name "Stabaxol P", and an aromatic polycarbodiimide, such as a benzene-2,4-diisocyanato-1,3,5-tris(1-methylethyl) homopolymer, which is produced by the company under a trade name "Stabaxol P100".

Among them, a compound having a molecular weight of 5,000 or more is preferred from the standpoint of the hydrolysis resistance under a high temperature environment exceeding 100°C, and examples of the carbodiimide compound having that molecular weight include an aromatic polycarbodiimide, such as a benzene-2,4-diisocyanato-1,3,5-tris(l-methylethyl) homopolymer, which is produced by the company under a trade name "Stabaxol P100".

The carbodiimide compound is preferably contained in an amount of 0.3 to 2.5 parts by weight, and more preferably 0.6 to 1.5 parts by weight, per 100 parts by weight of the polyethylene terephthalate. When the content of the carbodiimide compound is smaller than the lower limit, the further enhancement of the hydrolysis resistance may not be exhibited, and in the case where the film is aged for 4,000 hours under an environment with a temperature of 85°C and a humidity of 85%RH, the film may not maintain 40% or more of the elongation retention rate before aging. When the carbodiimide compound is used in an amount exceeding the upper limit, the further enhancement of the hydrolysis resistance may be saturated, and adverse affects, such as deterioration of productive efficiency due to increased viscosity of the polyethylene terephthalate, yellowing of the film and formation of foreign matters in the film due to reaction of the excessive carbodiimide compound, may occur.

In the case where the polyester film for protecting a rear surface of a solar cell is a laminated film, the carbodiimide compound is preferably contained in the substrate layer.

The method of adding the carbodiimide compound to the film is preferably such a method that a master batch containing the carbodiimide compound at a high concentration is produced, and the master batch is melt-kneaded with polyethylene terephthalate containing no carbodiimide compound to prepare a composition having a carbodiimide compound content controlled to the prescribed amount. The concentration of the carbodiimide compound in the master batch is preferably in a range of 5 to 20% by weight, more preferably 10 to 17% by weight, and most preferably 15% by weight, in terms of the amount of the carbodiimide compound based on the total weight of the master batch. As an alternative method, such a method may be employed that the carbodiimide compound is melted by heating to a liquid phase and added directly to the substrate layer in the course of the extruder.

## Ultraviolet Ray Absorbent

The polyester film for protecting a rear surface of a solar cell of the invention may further contain an ultraviolet ray absorbent, and particularly in a lamination structure where the substrate layer contains the rutile type titanium oxide particles and the surface layer contains no rutile type titanium oxide particle, the surface layer preferably contains an ultraviolet ray absorbent. In the lamination structure, the use of an ultraviolet ray absorbent in the surface layer not only suppresses deterioration of the polyethylene terephthalate constituting the surface layer due to an ultraviolet ray, but also prevents an ultraviolet ray from penetrating and reaching the substrate layer, thereby suppressing effectively yellowing due to deterioration of the polyethylene terephthalate constituting the substrate layer. Furthermore, in the case where the carbodiimide compound is contained in the substrate layer, the use of an ultraviolet ray absorbent in the surface layer suppresses effectively yellowing due to deterioration of the carbodiimide compound constituting the substrate layer.

The content of the ultraviolet ray absorbent is preferably in a range of 0.1 to 10 parts by weight per 100 parts of the polyethylene terephthalate constituting the surface layer, the lower limit is more preferably 0.5 part by weight, and

further preferably 1 part by weight, and the upper limit is more preferably 7 parts by weight, and more preferably 5 parts by weight.

When the content of the ultraviolet ray absorbent in the surface layer is smaller than the lower limit, the polyester in the surface layer is irradiated with solar light, and the polyethylene terephthalate in the surface layer may be deteriorated. Furthermore, the surface layer may not sufficiently absorb an ultraviolet ray contained in the solar light, and an ultraviolet ray reaches the substrate layer, thereby deteriorating the polyester and the carbodiimide compound in the substrate layer. When the content of the ultraviolet ray absorbent in the surface layer exceeds the upper limit, the film may be reduced in hydrolysis resistance, may be reduced in adhesiveness to EVA (ethylene vinyl acetate) as a filler of a solar cell, and may be rather yellowed.

With respect to the kind of the ultraviolet ray absorbent, one or both of a benzotriazole ultraviolet ray absorbent and a triazine ultraviolet ray absorbent is preferably contained.

Examples of the benzotriazole ultraviolet ray absorbent include 2,2'-methylenebis(4-(1,1,3,3-tetramethylbutyl)-6-2H-benzotriazol-2-yl)phenol and 2,4-bis(1-methyl-1-phenylethyl)-6-(2H-benzotriazol-2-yl)phenol.

Examples of the triazine ultraviolet ray absorbent include 2,4-diphenyl-6-(2-hydroxyphenyl-4-hexyloxyphenyl)-1,3,5-triazine, 2-(2-hydroxyphenyl-4-(2-ethylhexyloxyphenyl))-4,6-bis(4-phenylphenyl)-1,3,5-triazine and 2-(2-hydroxy-4-(1-octyloxycarbonylethoxy)-4,6-bis(4-phenylphenyl)-1,3,5-triazine.

The number average molecular weight of the ultraviolet ray absorbent is preferably 500 to 1,500, and the lower limit is more preferably 600. The ultraviolet ray absorbent may be converted to a high molecular weight material by introducing a polymerizable group or a reactive group, or may be incorporated into a synthetic resin. The use of the ultraviolet ray absorbent having a molecular weight within the range suppresses the amount of the ultraviolet ray absorbent that is thermally decomposed or evaporated in the production process of the film, thereby providing a sufficient capability of preventing deterioration due to an ultraviolet ray. Furthermore, the amount of the ultraviolet ray absorbent that bleeds on the film surface may be suppressed.

The ultraviolet ray absorbent in the invention preferably has a thermal weight loss rate on heating from room temperature to 250°C at a temperature increasing rate of 10°C per minute of 1% or less, and more preferably 0.5% or less. When the thermal weight loss rate measured under the aforementioned condition exceeds the upper limit, the ultraviolet ray absorbent may be thermally decomposed or evaporated in the production process of the film, which may adversely affect the production process and may prevent the desired concentration of the ultraviolet ray absorbent from being obtained.

The melting point of the ultraviolet ray absorbent in the invention is preferably 150 to 300°C. When the melting point is lower than 150°C, the heat resistance may be deteriorated, and the polyester composition is liable to be thermally decomposed on melt-kneading. When the melting point of the ultraviolet ray absorbent exceeds 300°C, the solubility thereof in the polyester is liable to be insufficient, which may cause dispersion failure.

Weight Average Molecular Weight

The polyethylene terephthalate constituting the white polyester film layer in the invention preferably has a weight average molecular weight of 44,000 to 61,000. When the weight average molecular weight of the polyethylene terephthalate constituting that layer is in the range, a film that has good heat resistance, hydrolysis resistance and delamination resistance may be obtained with high productivity. The weight average molecular weight is a characteristic feature after forming the film.

In the case where the polyester film for protecting a rear surface of a solar cell of the invention is a laminated film, it is preferred that the total polyethylene terephthalate over the laminated film has a weight average molecular weight within the range, and it is particularly preferred that all the polyethylene terephthalates of the layers of the laminated film each have a weight average molecular weight within the range.

The weight average molecular weight is influenced by the molecular weight of the polyethylene terephthalate used itself and the content of the rutile type titanium oxide particles.

Terminal Carboxyl Group Concentration

The polyethylene terephthalate constituting the white polyester film layer in the invention preferably has a terminal carboxyl group concentration in a range of 6 to 29 eq/ton, more preferably 6 to 24 eq/ton, and particularly preferably 6 to 20 eq/ton. When the terminal carboxyl group concentration is in the range, such a film may be obtained that is excellent in heat resistance and hydrolysis resistance and is suppressed in reduction of mechanical properties on long-term use under a high temperature and high humidity environment. For providing a film having a terminal carboxyl group concentration of less than 6 eq/ton, a polyester having a smaller terminal carboxyl group concentration is necessarily used as a raw material, and therefore, the polymerization time of the raw material is necessarily prolonged. The terminal carboxyl group concentration is a characteristic feature after forming the film.

In the case where the carbodiimide compound is used in the invention, the upper limit of the terminal carboxyl group concentration is preferably 17 eq/ton or less, and particularly preferably 15 eq/ton or less.

In the case where the polyester film for protecting a rear surface of a solar cell of the invention is a laminated film, it is preferred that the total polyethylene terephthalate over the laminated film has a terminal carboxyl group concentration within the range, and it is particularly preferred that all the polyethylene terephthalates of the layers of the laminated film each have a terminal carboxyl group concentration within the range.

Hydrolysis Resistance

The polyester film for protecting a rear surface of a solar cell of the invention has an elongation retention rate after aging for 3,000 hours under an environment with a temperature of 85°C and a humidity of 85%RH of 50% or more. The aging for 3,000 hours under an environment with a temperature of 85°C and a humidity of 85%RH is an example of an accelerated test for investigating the hydrolysis resistance corresponding to outdoor exposure for approximately 30 years. In the case where the elongation retention rate is smaller than 50%, there is a possibility that deterioration occurs on outdoor long-term use due to insufficient hydrolysis resistance, thereby reducing the mechanical properties. The elongation retention rate is preferably 55% or more, more preferably 60% or more, further preferably 65% or more, and particularly preferably 70% or more.

For providing the elongation retention rate under the environment of 50% or more, the film may be produced by using the phosphoric acid compound and the polycondensation catalyst in the prescribed amounts, according to the method described in the section of the production method, with the weight average molecular weight and the terminal carboxyl group concentration of the polyethylene terephthalate of the film within the ranges according to the invention.

In the case where the carbodiimide compound is used in the invention, the polyester film for protecting a rear surface of a solar cell of the invention preferably has an elongation retention rate after aging for 4,000 hours under an environment with a temperature of 85°C and a humidity of 85%RH of 40% or more, and more preferably 60% or more. The aging for 4,000 hours under an environment with a temperature of 85°C and a humidity of 85%RH is an accelerated test for investigating the hydrolysis resistance corresponding to outdoor exposure for approximately 40 years.

Delamination Strength (Initial)

The polyester film for protecting a rear surface of a solar cell of the invention has an initial delamination strength of 6 N/15 mm or more, and preferably 8 N/15 mm or more. The initial delamination strength herein means a peeling force obtained in such a manner that the film is adhered to a glass plate through an adhesive tape and peeled with a tensile tester after curing the adhesive, as described in detail in the section of the measurement method.

When the initial delamination strength is smaller than the lower limit, on using the film for protecting a rear surface of a solar cell, delamination may occur inside the film due to thermal expansion and contraction associated with circadian temperature variation and seasonal temperature variation, and the protection capability of the rear surface protective film may be deteriorated, thereby causing invasion of water into the module and deterioration of the solar cell element. A wiring box for withdrawing electric power from the solar cell module is attached to the rear surface protective film, and when the module is exposed to the weather outdoors, the wiring box may be dropped off due to delamination of the film.

For providing the initial delamination strength within the range for the white polyester film containing rutile type titanium oxide particles, the film may be produced with the polyethylene terephthalate for the film that has a weight average molecular weight within the range of the invention, according to the method described in the section of the production method, particularly by employing the stretching magnification and the heat treatment conditions described therein. The initial delamination strength is also influenced by the content of the rutile type titanium oxide particles.

Delamination Strength (after Hygrothermal Treatment)

The polyester film for protecting a rear surface of a solar cell of the invention preferably has a delamination strength after aging for 3,000 hours under an environment with a temperature of 85°C and a humidity of 85%RH of 4 N/15 mm or more, and more preferably 6 N/15 mm or more. When the delamination strength after subjecting to a hygrothermal treatment under the aforementioned conditions is in the range, such a polyester film for protecting a rear surface of a solar cell may be obtained that suffers no delamination even when the film is used outdoors as a rear surface protective film for a solar cell.

For providing the delamination strength after the hygrothermal treatment within the range for the white polyester film containing rutile type titanium oxide particles, the film may be produced with the polyethylene terephthalate for the film that has a weight average molecular weight within the range of the invention, according to the method described in the section of the production method, particularly by employing the stretching magnification and the heat treatment

conditions described therein.

In the case where the film contains the carbodiimide compound, the delamination strength after the hygrothermal treatment may be accomplished by providing a surface layer that contains substantially no carbodiimide compound and has a thickness of 3.0 μm or more on both surfaces of the substrate layer containing the carbodiimide compound. When the thickness of the surface layer is smaller than 3.0 μm, low molecular weight components may bleed out from the substrate layer, and it may be difficult to maintain the delamination strength after the 3,000-hour aging to 4 N/15 mm or more.

Thermal Contraction Rate

The polyester film for protecting a rear surface of a solar cell of the invention preferably has thermal contraction rates after subjecting to a heat treatment at 150°C for 30 minutes of -0.1 to 1.5%, more preferably -0.05 to 1.2%, and particularly preferably -0.01 to 1.0%, in both the machine direction and the transverse direction. When the film has the thermal contraction rates within the range, on providing a unit of solar cells with the film, the wiring may not be warped, and no displacement may occur in the solar cells. Furthermore, protrusion may not occur on adhering the film to a sealant by vacuum lamination, thereby preventing the productivity from being impaired. The negative value for the thermal contraction rate means that the size of the film after the heat treatment is larger than the original size.

Heat Resistance

The polyester film for protecting a rear surface of a solar cell of the invention preferably has an elongation retention rate after aging for 6,000 hours under an environment with a temperature of 130°C of 40% or more. A material used for protecting a rear surface of a solar cell is desirably certified by the RTI certificate of Underwriters Laboratories Inc. (which is hereinafter abbreviated as UL) at a temperature that is higher by 10 to 15°C than the maximum temperature that the solar cell reaches during operation. It has been stated that the maximum temperature of a solar cell module is around 100°C while it varies depending on the recent increase of the electric power generation by enhancing the efficiency of a solar cell module and also on the installation location of the module, and a material used as a rear surface protective film may be necessarily certified by the RTI value at 120°C or higher. As an index for the UL certification with the RTI value at 120°C or higher, the elongation retention rate after aging for 6,000 hours under an environment with a temperature of 130°C is preferably 40% or more, and more preferably 50% or more.

For providing the elongation retention rate of 40% or more, the film may be produced with the content of the rutile type titanium oxide particles in the polyester composition, the concentrations of the metal element and the phosphoric acid compound contained in the polyester composition, and the weight average molecular weight and the terminal carboxyl group concentration of the polyester in the film, that are within the ranges of the invention, according to the production method described later.

Weather Resistance

The polyester film for protecting a rear surface of a solar cell of the invention preferably has such weather resistance that the breaking elongation retention rate after irradiation of an ultraviolet ray is 80% or more, and more preferably 90% or more. When the film has a breaking elongation retention rate within the range, the polyester film for protecting a rear surface of a solar cell has high weather resistance and sufficiently protects the interior of the solar cell module, thereby preventing the sealant and the adhesive from being deteriorated. The breaking elongation retention rate is calculated from a breaking elongation before and after the film is irradiated with an ultraviolet ray with an irradiation intensity of 550 $W/m^2$ for 200 hours.

For providing the breaking elongation retention rate of 80% or more, rutile type titanium oxide particles may be used as titanium oxide particles constituting the film, and the concentration thereof may be in the range of the invention. In the case of the laminated film, it is important that the layer obtained by such a method is disposed on the light incident side.

Film Thickness

In the polyester film for protecting a rear surface of a solar cell of the invention, it is sufficient that the white polyester film layer has a thickness of 5 μm or more. When the layer has such a thickness, the film may be sufficiently suppressed from being deteriorated by an ultraviolet ray with the rutile type titanium oxide particles.

In both the cases of the single layer film and the laminated film, the total thickness of the film is preferably 25 to 250 μm, more preferably 40 to 250 μm, further preferably 45 to 220 μm, and particularly preferably 50 to 200 μm. When the thickness is in the range, a film that is excellent in hiding power, has stiffness and has good handleability on production may be produced with high productivity.

Laminated Film

In the case where the polyester film for protecting a rear surface of a solar cell of the invention is a laminated film, the laminated film preferably contains at least one layer of a white polyester film layer formed of a polyester composition containing 85 to 96% by weight of polyethylene terephthalate that is polymerized with an antimony compound and/or a titanium compound as a polycondensation catalyst and 4 to 15% by weight of rutile type titanium oxide particles.
Specific examples of the structure of the laminated film include a stretched film having a two-layer structure containing a substrate layer having provided on one surface thereof a surface layer, in which at least one of the layers is the white polyester film layer. Specific examples thereof also include a three-layer structure containing a substrate layer having provided on both surfaces thereof surface layers, in which at least one of the layers is the white polyester film layer.
In the case where two-layer laminated film, the white polyester film layer is preferably disposed on the outer side of the solar cell module.
In the case of the three-layer structure having surface layers provided on both surfaces of the substrate layer, the white polyester film layer may be any one of the surface layers and the substrate layer. By providing at least one layer of the white polyester film layer contained, the reflected light from the rear surface protective film for the solar cell may be effectively subjected to photoelectric conversion, and high weather resistance may be obtained. Simultaneously, other layers than the white polyester film layer preferably do not contain titanium oxide particles, or even though contained, the amount thereof is preferably limited to 2 parts by weight or less per 100 parts by weight of the polyethylene terephthalate constituting the other layers. In the case where other layers than the white polyester film layer contain titanium oxide particles, the amount thereof is more preferably 1.8 parts by weight or less, further preferably 1.5 parts by weight or less, and particularly preferably 1.0 part by weight or less. The lower limit of the content of the titanium oxide particles is preferably 0.05 part by weight, and more preferably 0.1 part by weight.
When the content of the titanium oxide particles in other layers than the white polyester film layer exceeds the upper limit, the polyester film may be deteriorated in hydrolysis resistance. In the case where the surface layer is the other layer than the white polyester film layer, when the content of the titanium oxide particles in the layer exceeds the upper limit, such influences may occur that the adhesiveness to EVA, which is a filler of the solar cell, is deteriorated, and cohesion failure of the film occurs on releasing the film or by influence of a member that is laminated thereto on forming a module by installing in a solar cell.
In the case where the polyester film of the invention contains a carbodiimide compound, it is preferred that the substrate layer contains the carbodiimide compound, and surface layers having a thickness of 3.0 μm or more formed of polyethylene terephthalate containing no carbodiimide compound are provided on both surfaces thereof.
The carbodiimide compound that is used for imparting hydrolysis resistance contains partially a low molecular weight component even though the compound has a high molecular weight. Accordingly, when such a structure is employed that the substrate layer is exposed on the surface, the low molecular weight component may bleed on the surface of the film with the lapse of time, which may deteriorate the delamination strength after subjecting to a hygrothermal treatment. For preventing the bleeding, surface layers containing no carbodiimide compound are preferably provided on both surfaces of the substrate layer, and the thickness of the surface layers is preferably 3.0μ m or more. The thickness of the surface layers is more preferably 5.0 μm or more. The upper limit of the thickness of the surface layers is, for example, approximately 12.0 μm, and further approximately 10.0 μm. The language, the surface layer contains no carbodiimide compound, means that the carbodiimide compound is completely not contained, or even though contained, the content thereof is such a level that the carbodiimide compound does not bleed on the surface. For example, when the content of the carbodiimide compound is 0.05 part by weight or less per 100 parts by weight of polyethylene terephthalate, it may be considered that no compound is contained in the invention. The surface layer preferably contains completely no carbodiimide compound.
On melt-extruding a polyester composition containing a carbodiimide compound, an isocyanate decomposition gas is ordinarily generated, which irritates the mucosa, and the working environment may be deteriorated. When both the surfaces of the substrate layer are covered with the surface layer having a thickness of 3.0 μm or more, the irritative gas may be prevented from occurring, and the film may be produced under a favorable working environment.
The thickness of the surface layer is the thickness after biaxial stretching, and the thickness of the surface layer of the laminated film immediately after the extrusion before stretching is, for example, 27 μm or more when the stretching magnification is 9 times in terms of area ratio, and 24 μm or more when the stretching magnification is 8 times.
In the laminated film containing the carbodiimide compound, the substrate layer may be advantageously thicker for imparting higher hydrolysis resistance, and for sufficiently preventing the bleeding and for providing the laminated film that is excellent in hydrolysis resistance, the thickness ratio of the surface layers and the substrate layer (surface layer)/(substrate layer)/(surface layer) is preferably in a range of 1/6/1 to 1/12/1.

Additives

The polyester film for protecting a rear surface of a solar cell of the invention may contain, in addition to the rutile type titanium oxide particles, a lubricant for enhancing the sliding on the surface to improve the handleability. The lubricant used may an organic lubricant or an inorganic lubricant, and examples of the inorganic lubricant include particles of barium sulfate, calcium carbonate, silicon dioxide or alumina. The average particle diameter of the particles used is preferably 0.1 to 5.0 0 μm, and more preferably 0.2 to 4.0 μm from the standpoint of the dispersibility and slidability. The shape of the particles may be a plate shape or a spherical shape. Some lubricants are liable to absorb water or liable to coordinate water, and water entrained with the lubricant may lower the molecular weight of the film, thereby providing poor heat resistance and hydrolysis resistance. Accordingly, the lubricant preferably has such structure and composition that have a small amount of adsorbed water and coordinated water. Particularly preferred examples of the lubricant include spherical silica.

The amount of the lubricant added is preferably as small as possible from the standpoint of the hydrolysis resistance, and in the case of the laminated film, the lubricant is preferably added only to the surface layer, and the amount thereof is preferably 0.1 part by weight or less per 100 parts by weight of the polyethylene terephthalate in the surface layer.

Furthermore, for further enhancing the capability, depending on necessity, the polyester film for protecting a rear surface of a solar cell of the invention may contain various known additives, and for example, an antioxidant, an antistatic agent and a flame retardant may be added. Examples of the antioxidant include a hindered phenol compound. The additives may be added to the film or applied on the film, thereby exhibiting the functions thereof, or in alternative, the polyester film may be formed to have a laminated structure, in which the additives may be added to at least one layer thereof.

Rear Surface Protective Film for Solar Cell

The polyester film for protecting a rear surface of a solar cell of the invention may be used solely as a rear surface protective film for a solar cell, or a laminate with other sheets laminated thereon may be used as a rear surface protective film for a solar cell. Examples of the laminate include a laminate having another polyester film adhered for enhancing the insulating property, and a laminate having a film formed of a resin having high weather resistance adhered for enhancing the durability.

Upon using the film as a rear surface protective film for a solar cell, a water vapor barrier layer is preferably laminated for imparting water vapor barrier property. A rear surface protective film for a solar cell having the structure preferably has a permeability of water vapor measured according to JIS Z0208-73 of 5 g/($m^2$·24 h) or less. The water vapor barrier layer used may be a film or a foil that has water vapor barrier property. Examples of the film include a polyvinylidene chloride film, a polyvinilidene chloride coated film, a polyvinylidene fluoride coated film, a silicon oxide vapor-deposited film, an aluminum oxide vapor-deposited film and an aluminum vapor-deposited film, and examples of the foil include an aluminum foil and a copper foil.

A water vapor barrier layer may be applied or vapor-deposited directly on the polyester film for protecting a rear surface of a solar cell of the invention. The water vapor barrier layer may be used, for example, in such a manner that upon using the polyester film of the invention is adhered to an EVA layer, the water vapor barrier layer is laminated on the opposite side of the surface where the EVA layer is adhered, or another film may be further laminated thereon, thereby holding the water vapor barrier layer with plural films.

Production Method

The production method of the polyethylene terephthalate used on producing the polyester film for protecting a rear surface of a solar cell of the invention will be described. A glass transition temperature of a polymer may be expressed as Tg, and a melting point thereof may be expressed as Tm.

Examples of the production method of the polyethylene terephthalate used in the invention include a method of subjecting an aromatic dicarboxylic acid, such as terephthalic acid, and ethylene glycol to esterification reaction and then performing polycondensation reaction, and a method of subjecting an aromatic dicarboxylate ester represented by dimethyl terephthalate and ethylene glycol to ester exchange reaction and then performing polycondensation reaction. For example, in the production process using ester exchange reaction, the ester exchange reaction is performed while removing an alcohol generated, then the ester exchange reaction is substantially completed while adding the phosphoric acid compound of the invention, and subsequently an antimony compound and/or a titanium compound is added to the resulting reaction product to perform polycondensation reaction.

For providing a polyester film having higher hydrolysis resistance, it is important to increase the limiting viscosity number of the polyester raw material and to decrease the terminal carboxyl group concentration thereof, and solid phase

polymerization is preferably added. Furthermore, the phosphoric acid compound of the invention is preferably added in the initial phase of the polycondersation reaction, the polycondensation reaction is preferably performed at a temperature of the melting point of the polyethylene terephthalate to 295°C, and the polycondensation reaction is particularly preferably performed at a temperature of the melting point of the polyethylene terephthalate to 280°C. By using the phosphoric acid compound of the invention, the solid phase polymerization may be performed within a shorter period of time, preferably 3 to 12 hours, and more preferably 5 to 10 hours.

In the case where rutile type titanium oxide particles are added, and in the case where a carbodiimide compound is added, it is preferred that the polyester raw material and master chips of the additives are mixed at a prescribed mixing ratio, and then dried depending on necessity. The master chips may be prepared for the respective additives, or master chips containing plural additives may be prepared.

The polyester film for protecting a rear surface of a solar cell of the invention may be produced according to a known film forming method. An example of the method will be described. A polyester as a raw material is melt-extruded from a slit die into a film form, which is cooled for solidification on a casting drum, thereby forming an unstretched film. The resulting unstretched film is the stretched at least uniaxially, preferably biaxially. The stretching may be sequential biaxially stretching or simultaneous biaxial stretching. In sequential biaxial stretching, for example, the unstretched film is heated by a roll heating, infrared ray heating or the like, and stretched in the machine direction, thereby providing a machine direction stretched film. The stretching operation is preferably performed by utilizing a difference in peripheral speed of two or more rolls. The stretching temperature is preferably Tg of the polyester or more, and more preferably in a range of Tg to (Tg + 70°C). The film having been stretched in the machine direction is then subjected to stretching in the transverse direction, heat setting and heat relaxation sequentially, thereby providing a biaxially oriented film, and these processes are performed while running the film. The stretching in the transverse direction is started at a temperature that is higher than Tg of the polyester, and performed while increasing the temperature to a temperature that is higher than Tg by (5 to 70°C). The temperature increase on stretching in the transverse direction may be continuous or stepwise (sequential), and the temperature is generally increased sequentially. For example, the transverse stretching zone of the tenter is divided in the film running direction into plural zones, and the zones are heated by feeding heating media with prescribed temperature respectively.

In the case of the laminated structure, a simultaneous multilayer extrusion method may be performed, in which the raw materials of the layers are dried depending on necessity, and the raw materials of the layers are melt-mixed in separate extruders, laminated with a feed block, and then extruded from a slit die, thereby providing an unstretched film. In the case of a three-layer structure, for example, a melt of a polymer constituting the surface layer and a melt of a polymer constituting the substrate layer are laminated with a feed block into a three-layer structure of surface layer/ substrate layer/surface layer, and then spread to a slit die for extruding. At this time, the polymers thus laminated in the feed block maintain the laminated form. When the temperature where the melt mixing is performed is lower than 280°C, the resins may be insufficiently melted, which may increase the load on the extruder. When the temperature exceeds 300°C, deterioration of the resins may proceed, and consequently the film may be deteriorated in hydrolysis resistance.

The stretching magnification in both the machine direction and the direction perpendicular to the machine direction (which may be hereinafter referred to a transverse direction) may be in a range of 2.8 to 4.0 times, and more preferably 3.0 to 3.8 times. When the stretching magnification is smaller than 2.8 times, not only the film may suffer large unevenness in thickness, but also the heat resistance and the hydrolysis resistance thereof may be lowered. When the stretching magnification exceeds 4.0 times, the delamination strength of the film containing the white polyester film of the invention may be lowered.

The film after subjecting to the transverse stretching may be subjected to a heat treatment at a temperature of (Tm - 20) to (Tm - 55)°C while holding both edges of the film, thereby enhancing both the hydrolysis resistance and the delamination resistance characteristics. The film may be subjected to a heat treatment at that temperature with a constant width or at a width decreasing rate of 10% or less for decreasing the thermal contraction rate, thereby enhancing the dimensional stability. When the film is subjected to a heat treatment at a temperature that is higher than (Tm - 20)°C, the film may be deteriorated in flatness, and not only the film may suffer large unevenness in thickness, but also the hydrolysis resistance may be deteriorated. When the film is subjected to a heat treatment at a temperature lower than (Tm - 55)°C, the heat contraction ratio may be increased, and also the delamination resistance property may be deteriorated.

As a method of controlling the thermal contraction amount at a heat treatment temperature of (Tm - 55)°C or lower, such a method may be employed that the held both edges of the film are cut out in the process where the film temperature is returned to room temperature after the heat setting, and the withdrawing speed in the machine direction of the film is controlled to relax the film in the machine direction (JP-A-57-57628). For relaxing the film, the speeds of the rolls on the outlet of the tenter are controlled. As for the ratio of relaxing, the speeds of the rolls are lowered with respect to the film line speed of the tenter, preferably lowered by 1.0 to 4.0%, and more preferably 1.2 to 3.5%, thereby relaxing the film (where these values are referred to a relaxing ratio), and the relaxing ratio is controlled to control the thermal contraction rate in the machine direction. As the method of enhancing the dimensional stability, an intended

thermal contraction rate may be obtained by decreasing the width of the film in the process until cutting out both edges thereof.

The polyester film for protecting a rear surface of a solar cell of the invention may be laminated with another sheet through an adhesive to constitute a rear surface protective film, or a sealant resin of a solar cell element may be provided directly thereon. For enhancing the adhesiveness of the polyester film to the adhesive and the sealant resin, an easy adhesive coating may be formed on one surface of the film for protecting a rear surface of a solar cell of the invention. Examples of the adhesive that is frequently used include an epoxy adhesive and a urethane adhesive. The sealant may be EVA (ethylene-vinyl acetate) in most cases. The material constituting the easy adhesive coating is preferably such a material that exhibits excellent adhesiveness to both the polyester film and the adhesive or EVA, examples of which include a polyester resin and an acrylic resin, and the material preferably contains a crosslinking component. The coating operation may be performed by a known coating method. Preferably, the coating operation may be performed by an in-line coating method, in which an aqueous liquid containing the material constituting the coating layer is applied on the stretchable polyester film, and then the polyester film is dried, stretched and heat-treated. The thickness of the coating film formed on the film is preferably 0.01 to 1 μm.

Example

The invention will be described in detail with reference to examples below. The evaluation methods are described below.

(1) Film Thickness

A film specimen was measured for thickness at 10 positions with an electric micrometer (K-402B, produced by Anritsu Corporation), and an average value was designated as thickness.

(2) Limiting Viscosity Number (η)

A specimen was dissolved in a mixed solvent of phenol and tetrachloroethane at a weight ratio of 6/4, and the solution viscosity was measured at 35°C. A value calculated from the following expression was used as the limiting viscosity number.

$$\eta sp/C = [\eta] + K[\eta]^2 \cdot C$$

In the expression, ηsp = (solution viscosity/solvent viscosity) - 1; C is the dissolved polymer weight (g/100 mL) per 100 mL of the solvent; and K is the Huggins constant. The solution viscosity and the solvent viscosity were measured with an Ostwald viscometer. The unit is dL/g.

(3) Weight Average Molecular Weight

1 mg of a film specimen was dissolved in 0.5 mL of HFIP/choroform (1/1) (overnight). 9.5 mL of chloroform was added to the solution immediately before the measurement, and the solution was filtered through a membrane filter of 0.1 μm and subjected to GPC analysis. The measurement equipments and conditions were as follows.
GPC: HLC-8020, produced by Tosoh Corporation
detector: UV-8010, produced by Tosoh Corporation
columns: TSK-gel IGMHHR·M × 2, produced by Tosoh Corporation
mobile phase: chloroform for HPLC
flow rate: 1.0 mL/min
column temperature: 40°C
detector: UV (254 nm)
injection amount: 200 μL
sample for calibration curve: polystyrene (EasiCal PS-1, produced by Polymer Laboratories, Ltd.)

(4) Terminal Carboxyl Group Concentration

10 mg of a specimen was dissolved in 0.5 mL of a mixed solvent of HFIP (hexafluoroisopropanol)/deuterated chloroform = 1/3, to which several drops of isopropylamine was added, and measured by a $^1$H-NMR method (50°C, 600

MHz).

(5) Hydrolysis Resistance

(i) Hydrolysis resistance at temperature of 85°C and humidity of 85%RH for 3,000 hours

A test piece was cut out from the film in a strip form of 100 mm in length in the machine direction of the film and 10 mm in width in the transverse direction thereof, and was placed in an environment tester set at a temperature of 85°C and a humidity of 85%RH for 3,000 hours. The test piece was taken out and measured for breaking elongation in the machine direction at 5 positions, and the average value was obtained. The tensile test was performed by using Tensilon, a trade name, produced by Toyo Baldwin Corporation, with a chuck distance of 50 mm and a tensile speed of 50 mm/min. A value obtained by dividing the average value of the 5 positions by an average value of breaking elongation of 5 positions before performing the environment test was designated as the breaking elongation retention rate (%), and the hydrolysis resistance was evaluated thereby according to the following standard. A specimen having a larger breaking elongation retention rate was determined as one having better hydrolysis resistance.
breaking elongation retention rate (%) = ((breaking elongation after 3,000-hour treatment)/(breaking elongation before treatment)) × 100

A: breaking elongation of 70% or more
B: breaking elongation of 50% or more and less than 70%
C: breaking elongation of less than 50%

(ii) Hydrolysis resistance at temperature of 85°C and humidity of 85%RH for 4,000 hours

The breaking elongation retention rate (%) was obtained under the same conditions as in the hydrolysis resistance test in the item (i) above except that the test time was changed from 3,000 hours to 4,000 hours, and the hydrolysis resistance was evaluated thereby according to the following standard.

breaking elongation retention rate (%) = ((breaking elongation after 4,000-hour treatment)/(breaking elongation before treatment)) × 100

A: breaking elongation of 60% or more
B: breaking elongation of 40% or more and less than 60%
C: breaking elongation of less than 40%

(6) Delamination Strength (Initial Value)

A specimen slit into a strip form with a width of 15 mm was adhered to a glass plate through a noncarrier adhesive tape (MHM-25, produced by Nichiei Kakoh Co., Ltd., thickness: 25 μm), and the adhesive was cured by hot air drying at 180°C for 30 minutes. In the case of a film having two-layer structure, a layer that had a smaller content of rutile type titanium oxide particles was adhered to the adhesive tape.
The assembly was set in a tensile tester, and peeled at 180° at a tensile speed of 500 mm/min, thereby forcedly generating delamination within the film. The peeling force in the state where delamination occurred was read out and designated as the delamination strength (unit: N/15 mm). In the case where delamination did not occur, but the film was broken, it was determined that the delamination strength was sufficiently large, and the specimen was evaluated as A.

A: delamination strength of 8 N/15 mm or more
B: delamination strength of 6 N/15 mm or more and less than 8 N/15 mm
C: delamination strength of less than 6 N/15 mm

(7) Delamination Strength (after Hygrothermal Treatment)

The film was retained in an atmosphere of a temperature of 85°C and a humidity of 85%RH for 3,000 hours, and then the production of the specimen and the 180° peeling test was performed in the same manner as in the item (6) above, thereby measuring the delamination strength after the hygrothermal treatment (unit: N/15 mm).

(8) Heat Resistance

A test piece was cut out from the film in a strip form of 150 mm in length in the machine direction of the film and 10 mm in width in the transverse direction thereof, and was placed in an oven set at a temperature of 130°C for 6,000 hours. The test piece was taken out and measured for breaking elongation in the machine direction at 5 positions, and the average value was obtained. The tensile test was performed by using Tensilon, a trade name, produced by Toyo Baldwin Corporation, with a chuck distance of 100 mm and a tensile speed of 100 mm/min. A value obtained by dividing the average value of the 5 positions by an average value of breaking elongation of 5 positions before performing the heat resistance test was designated as the breaking elongation retention rate (%), and the heat resistance was evaluated thereby. A specimen having a larger breaking elongation retention rate was determined as one having better heat resistance.

breaking elongation retention rate (%) = ((breaking elongation after 6,000-hour treatment)/(breaking elongation before treatment)) × 100

(9) Weather Resistance

The evaluation was performed according to JIS K7350-2. A test piece that was cut out from the film in a strip form of 75 mm in length in the machine direction of the film and 10 mm in width in the transverse direction thereof was irradiated with an ultraviolet ray at an irradiation strength of 550 W/$m^2$ with a xenon weather meter (X75, produced by Suga Test Instruments Co., Ltd.) for 200 hours under water spraying for 18 minutes per 2 hours. The test piece was then measured for breaking elongation in the machine direction at 5 positions, and the average value was obtained. The tensile test was performed by using Tensilon, a trade name, produced by Toyo Baldwin Corporation, with a chuck distance of 50 mm and a tensile speed of 50 mm/min. A value obtained by dividing the average value of the 5 positions by an average value of breaking elongation of 5 positions before performing the irradiation was designated as the breaking elongation retention rate (%), and the weather resistance was evaluated thereby according to the following standard. A specimen having a larger breaking elongation retention rate was determined as one having better weather resistance.

breaking elongation retention rate (%) = ((breaking elongation after 200-hour irradiation)/(breaking elongation before irradiation)) × 100

(10) Average Particle Diameter

Particles were measured for particle size distribution with a particle size distribution analyzer (LA-950, produced by Horiba, Ltd.), and a particle diameter at d50 was designated as an average particle diameter.

(11) Layer Structure

A specimen was cut into a triangular shape, and after fixing in an embedding capsule, the specimen was embedded in an epoxy resin. The embedded specimen was sliced in parallel to the machine direction into a section with a thickness of 50 nm with a microtome (ULTRACUT-S), and observed with a transmission electron microscope at an acceleration voltage of 100 kV. The layers were measured for thickness from the micrograph, and an average thickness was obtained.

Reference Example 1

Production of Polyethylene Terephthalate (PET-a)

100 parts by weight of dimethyl terephthalate, 60 parts by weight of ethylene glycol and manganese acetate tetrahydrate were charged in an ester exchange reaction vessel, and melted and stirred under heating to 150°C. The reaction was performed while gradually increasing the temperature inside the reaction vessel to 235°C, and methanol produced was distilled out from the reaction vessel. After completing the distillation of methanol, phenylphosphonic acid was added thereto, and the ester exchange reaction was completed. Thereafter, the reaction product was placed in a polycondensation apparatus, to which both antimony oxide and titanium acetate were added.
Subsequently, the temperature inside the polymerization apparatus was increased from 235°C to 290°C over 90 minutes, and simultaneously the pressure inside the apparatus was decreased from the atmospheric pressure to 100 Pa over 90 minutes. When the stirring torque of the content of the polymerization apparatus reached the prescribed value, the interior of the apparatus was returned to the atmospheric pressure with nitrogen gas, and the polymerization was completed. The valve at the lower part of the polymerization apparatus was opened, and the interior of the polymerization apparatus was pressurized with nitrogen gas, thereby discharging polyethylene terephthalate thus polymerized in the form of strand into water. The strand was cut with a cutter to form chips.

Thus, a polymer of polyethylene terephthalate having a limiting viscosity number of 0.64 dL/g and a terminal carboxyl group concentration of 17 eq/ton was obtained. In the polymer, the concentrations of the polycondensation catalyst and the phosphoric acid compound were 30 millimole % for Mn, 20 millimole % for Sb, 3 millimole % for Ti, and 15 millimole % for phenylphosphonic acid. The polymer was designated as PET-a.

Reference Example 2

Production of Polyethylene Terephthalate (PET-b)

The polymer (PET-a) obtained in Reference Example 1 was preliminarily dried at 150 to 160°C for 3 hours, and then subjected to solid phase polymerization at 210°C and 100 Torr in a nitrogen gas atmosphere for 7 hours. After completing the solid phase polymerization, the limiting viscosity number was 0.82 dL/g, and the terminal carboxyl group concentration was 10 eq/ton. The resulting polymer was designated as PET-b.

Reference Example 3

Production of Polyethylene Terephthalate (PET-c)

The polymer (PET-a) obtained in Reference Example 1 was preliminarily dried at 150 to 160°C for 3 hours, and then subjected to solid phase polymerization at 210°C and 100 Torr in a nitrogen gas atmosphere for 10 hours. After completing the solid phase polymerization, the limiting viscosity number was 0.90 dL/g, and the terminal carboxyl group concentration was 8 eq/ton. The resulting polymer was designated as PET-c.

Reference Example 4

Production of Polyethylene Terephthalate (PET-d)

40 parts by weight of the polymer (PET-a) obtained in Reference Example 1 and 60 parts by weight of rutile type titanium oxide particles (average particle diameter: 0.2 μm), TCR-52, produced by Sakai Chemical Industry Co., Ltd., were mixed, fed to a twin screw kneader, and melted at 280°C. The polyester composition thus melt-kneaded was ejected in the form of strand into water, and cut to form chips. The resulting polymer was designated as PET-d.

Reference Example 5

Production of Polyethylene Terephthalate (PET-e)

60 parts by weight of the polymer (PET-a) obtained in Reference Example 2 and 40 parts by weight of rutile type titanium oxide particles (average particle diameter: 0.2 μm), TCR-52, produced by Sakai Chemical Industry Co., Ltd., were mixed, fed to a twin screw kneader, and melted at 280°C. The polyester composition thus melt-kneaded was ejected in the form of strand into water, and cut to form chips. The resulting polymer was designated as PET-e.

Reference Example 6

Production of Polyethylene Terephthalate (PET-f)

60 parts by weight of the polymer (PET-c) obtained in Reference Example 3 and 40 parts by weight of rutile type titanium oxide particles (average particle diameter: 0.2 μm), TCR-52, produced by Sakai Chemical Industry Co., Ltd., were mixed, fed to a twin screw kneader, and melted at 280°C. The polyester composition thus melt-kneaded was ejected in the form of strand into water, and cut to form chips. The resulting polymer was designated as PET-f.

Reference Example 7

Production of Polyethylene Terephthalate (PET-g)

60 parts by weight of the polymer (PET-b) obtained in Reference Example 2 and 40 parts by weight of anatase type titanium oxide particles (average particle diameter: 0.2 μm), KA-30T, produced by Titan Kogyo, Ltd., were mixed, fed to a twin screw kneader, and melted at 280°C. The polyester composition thus melt-kneaded was ejected in the form of strand into water, and cut to form chips. The resulting polymer was designated as PET-g.

Reference Example 8

Production of Polyethylene Terephthalate (PET-h and PET-i)

The same procedures as in Reference Example 1 were performed except that titanium acetate was not used as the polycondensation catalyst, but only antimony oxide was used, and orthophosphoric acid was used as the phosphoric acid compound, thereby providing a polymer of polyethylene terephthalate having a limiting viscosity number of 0.64 dL/g, a terminal carboxyl group concentration of 25 eq/ton, a Mn concentration of 30 millimole %, a Sb concentration of 20 millimole %, and a concentration of orthophosphoric acid of 15 millimole %. The resulting polymer was preliminarily dried at 150 to 160°C for 3 hours, and then subjected to solid phase polymerization at 210°C and 100 Torr in a nitrogen gas atmosphere for 10 hours. After completing the solid phase polymerization, the limiting viscosity number was 0.82 dL/g, and the terminal carboxyl group concentration was 18 eq/ton. The resulting polymer was designated as PET-h.

60 parts by weight of the resulting polymer (PET-h) and 40 parts by weight of rutile type titanium oxide particles (average particle diameter: 0.2 μm), TCR-52, produced by Sakai Chemical Industry Co., Ltd., were mixed, fed to a twin screw kneader, and melted at 280°C. The polyester composition thus melt-kneaded was ejected in the form of strand into water, and cut to form chips. The resulting polymer was designated as PET-i.

Reference Example 9

Production of Polyethylene Terephthalate (PET-j and PET-k)

The same procedures as in Reference Example 1 were performed except that the content of phenylphosphonic acid was controlled to 5 millimole %, thereby providing a polymer of polyethylene terephthalate having a limiting viscosity number of 0.64 dL/g and a terminal carboxyl group concentration of 25 eq/ton. The resulting polymer was preliminarily dried at 150 to 160°C for 3 hours, and then subjected to solid phase polymerization at 210°C and 100 Torr in a nitrogen gas atmosphere for 10 hours. After completing the solid phase polymerization, the limiting viscosity number was 0.82 dL/g, and the terminal carboxyl group concentration was 18 eq/ton. The resulting polymer was designated as PET-j.

60 parts by weight of the resulting polymer (PET-j) and 40 parts by weight of rutile type titanium oxide particles (average particle diameter: 0.2 μm), TCR-52, produced by Sakai Chemical Industry Co., Ltd., were mixed, fed to a twin screw kneader, and melted at 280°C. The polyester composition thus melt-kneaded was ejected in the form of strand into water, and cut to form chips. The resulting polymer was designated as PET-k.

Reference Example 10

Production of Polyethylene Terephthalate (PET-1 and PET-m)

The same procedures as in Reference Example 1 were performed except that the content of phenylphosphonic acid was controlled to 50 millimole %, thereby providing a polymer of polyethylene terephthalate having a limiting viscosity number of 0.64 dL/g and a terminal carboxyl group concentration of 25 eq/ton. The resulting polymer was preliminarily dried at 150 to 160°C for 3 hours, and then subjected to solid phase polymerization at 210°C and 100 Torr in a nitrogen gas atmosphere for 7 hours. After completing the solid phase polymerization, the limiting viscosity number was 0.82 dL/g, and the terminal carboxyl group concentration was 10 eq/ton. The resulting polymer was designated as PET-1.

60 parts by weight of the resulting polymer (PET-1) and 40 parts by weight of rutile type titanium oxide particles (average particle diameter: 0.2 μm), TCR-52, produced by Sakai Chemical Industry Co., Ltd., were mixed, fed to a twin screw kneader, and melted at 280°C. The polyester composition thus melt-kneaded was ejected in the form of strand into water, and cut to form chips. The resulting polymer was designated as PET-m.

Reference Example 11

Production of Polyethylene Terephthalate (PET-n)

85% by weight of the polymer (PET-b) obtained in Reference Example 2 and 15% by weight of an aromatic polycarbodiimide, Stabaxol P100, produced by Rhein Chemie Rheinau GmbH, were mixed, fed to a twin screw kneader, and melted at 280°C. The polyester composition thus melt-kneaded was ejected in the form of strand into water, and cut to form chips. The resulting polymer was designated as PET-n.

Examples 1 to 3

The polyester raw materials were mixed at the mixing ratios shown in Table 1 and dried in a rotation vacuum drier at 180°C for 3 hours, and the mixture was fed to an extruder and melt-extruded at 285°C from a slit die into a sheet form. The sheet was cooled and solidified with a cooling drum having a surface temperature of 20°C to provide an unstretched film, which was stretched 3.4 times in the longitudinal direction (machine direction) at 100°C, and then cooled with rolls at 25°C. Subsequently, the film having been stretched in the machine direction was introduced into a tenter and stretched 3.7 times in the direction perpendicular to the longitudinal direction (transverse direction) in an atmosphere heated to 130°C while both ends of the film was held with clips. Thereafter, the film was heat-set for 15 seconds in an atmosphere heated to 222°C in the tenter for reducing the width by 4.0% in the transverse direction, both edges of the film were cut out, and the film was relaxed in the longitudinal direction at a relaxing ratio of 2.5% and then cooled to room temperature, thereby providing a polyester film having a thickness of 75 μm. The characteristics of the resulting films were as shown in Table 2.

Table 1

| | Film structure | | | | | | Contents in composition | | | | |
|---|---|---|---|---|---|---|---|---|---|---|---|
| | Layer (A) | | Layer (B) | | Thickness ratio (%) (A)/(B) | Thickness (μm) | Catalyst metal element (millimole %) | | | Phosphoric acid compound | |
| | Composition | Titanium oxide amount (wt%) | Composition | Titanium oxide amount (wt%) | | | Mn | Sb | Ti | Kind | Content (millimole %) |
| Example 1 | mixture of PET-b (82 parts by weight) and PET-e (18 parts by weight) | 7.2 | - | - | 100/0 | 75 | 30 | 20 | 3 | phenylphosphonic acid | 15 |
| Example 2 | mixture of PET-c (82 parts by weight) and PET-f (18 parts by weight) | 7.2 | - | - | 100/0 | 75 | 30 | 20 | 3 | phenylphosphonic acid | 15 |
| Comparative Example 1 | mixture of PET-a (88 parts by weight) and PET-d (12 parts by weight) | 7.2 | - | - | 100/0 | 75 | 30 | 20 | 3 | phenylphosphonic acid | 15 |

(continued)

| | Film structure | | | | | | Contents in composition | | | | |
|---|---|---|---|---|---|---|---|---|---|---|---|
| | Layer (A) | | Layer (B) | | Thickness ratio (%) (A)/(B) | Thickness (μm) | Catalyst metal element (millimole %) | | | Phosphoric acid compound | |
| | Composition | Titanium oxide amount (wt%) | Composition | Titanium oxide amount (wt%) | | | Mn | Sb | Ti | Kind | Content (millimole %) |
| Example 3 | mixture of PET-b (65 parts by weight) and PET-e (35 parts by weight) | 14 | - | - | 100/0 | 75 | 30 | 20 | 3 | phenylphosphonic acid | 15 |
| Comparative Example 2 | mixture of PET-b (50 parts by weight) and PET-e (50 parts by weight) | 20 | - | - | 100/0 | 75 | 30 | 20 | 3 | phenylphosphonic acid | 15 |
| Comparative Example 3 | mixture of PET-b (95 parts by weight) and PET-e (5 parts by weight) | 2 | - | - | 100/0 | 75 | 30 | 20 | 3 | phenylphosphonic acid | 15 |
| Comparative Example 4 | mixture of PET-b (82 parts by weight) and PET-g (18 parts by weight) | 7.2 | - | - | 100/0 | 75 | 30 | 20 | 3 | phenylphosphonic acid | 15 |

(continued)

| | Film structure | | | | | | Contents in composition | | | | |
|---|---|---|---|---|---|---|---|---|---|---|---|
| | Layer (A) | | Layer (B) | | Thickness ratio (%) (A)/(B) | Thickness (μm) | Catalyst metal element (millimole %) | | | Phosphoric acid compound | |
| | Composition | Titanium oxide amount (wt%) | Composition | Titanium oxide amount (wt%) | | | Mn | Sb | Ti | Kind | Content (millimole %) |
| Example 4 | mixture of PET-b (65 parts by weight) and PET-e (35 parts by weight) | 14 | PET-b | 0.0 | 20/80 | 75 | 30 | 20 | 3 | phenylphosphonic acid | 15 |
| Comparative Example 5 | mixture of PET-b (65 parts by weight) and PET-e (35 parts by weight) | 14 | PET-a | 0.0 | 20/80 | 75 | 30 | 20 | 3 | phenylphosphonic acid | 15 |
| Comparative Example 6 | mixture of PET-h (82 parts by weight) and PET-i (18 parts by weight) | 7.2 | - | - | 100/0 | 75 | 30 | 20 | - | orthophosphoric acid | 15 |
| Comparative Example 7 | mixture of PET-j (82 parts by weight) and PET-k (18 parts by weight) | 7.2 | - | - | 100/0 | 75 | 30 | 20 | 3 | phenylphosphonic acid | 5 |

(continued)

| | Film structure | | | | | | Contents in composition | | | | |
|---|---|---|---|---|---|---|---|---|---|---|---|
| | Layer (A) | | Layer (B) | | Thickness ratio (%) (A)/(B) | Thickness (μm) | Catalyst metal element (millimole %) | | | Phosphoric acid compound | |
| | Composition | Titanium oxide amount (wt%) | Composition | Titanium oxide amount (wt%) | | | Mn | Sb | Ti | Kind | Content (millimole %) |
| Comparative Example 8 | mixture of PET-l (82 parts by weight) and PET-m (18 parts by weight) | 7.2 | - | - | 100/0 | 75 | 30 | 20 | 3 | phenylphosphonic acid | 50 |
| Comparative Example 9 | mixture of PET-b (82 parts by weight) and PET-e (18 parts by weight) | 7.2 | - | - | 100/0 | 75 | 30 | 20 | 3 | phenylphosphonic acid | 15 |
| Comparative Example 10 | mixture of PET-b (82 parts by weight) and PET-e (18 parts by weight) | 7.2 | - | - | 100/0 | 75 | 30 | 20 | 3 | phenylphosphonic acid | 15 |

Table 2

| | Film characteristics | | | | | | Film characteristics | | | | |
|---|---|---|---|---|---|---|---|---|---|---|---|
| | Weight average molecular weight | Terminal carboxyl group concentration (eq/ton) | Hydrolysis resistance Breaking elongation retention rate after 85°C 85%RH 3,000 hr (%) | | Hydrolysis resistance Breaking elongation retention rate after 85°C 85%RH 4,000 hr (%) | | Delamination strength (N/15 mm) | | | Heat resistance Breaking elongation retention rate after 130°C 6,000 hr (%) | Heat resistance Breaking elongation retention rate after xenon irradiation 200hr (%) |
| | | | | | | | Initial value | | After 85°C 85%RH 3,000 hr | | |
| Example 1 | 51,300 | 22 | 60 | B | 15 | C | 6.3 | B | 4.1 | 50 | 95 |
| Example 2 | 58,600 | 16 | 75 | A | 39 | C | 8.2 | A | 6.0 | 60 | 98 |
| Comparative Example 1 | 40,000 | 31 | 45 | C | 0 | C | 4.5 | C | 2.3 | 37 | 90 |
| Example 3 | 48,900 | 24 | 57 | B | 10 | C | 6.1 | B | 3.8 | 50 | 98 |
| Comparative Example 2 | 41,600 | 30 | 45 | C | 0 | C | 3.5 | C | 1.9 | 40 | 99 |
| Comparative Example 3 | 55,000 | 19 | 67 | B | 35 | C | 8.5 | A | 6.7 | 57 | 40 |
| Comparative Example 4 | 51,500 | 22 | 62 | B | 34 | C | 6.4 | B | 4.1 | 54 | 60 |
| Example 4 | 53,700 | 20 | 65 | B | 34 | C | 10 | A | 8.0 | 56 | 98 |
| Comparative Example 5 | 42,800 | 29 | 47 | C | 0 | C | 5.9 | C | 3.9 | 42 | 95 |
| Comparative Example 6 | 47,600 | 30 | 48 | C | 0 | C | 6.0 | B | 3.9 | 43 | 95 |
| Comparative Example 7 | 48,000 | 30 | 48 | C | 0 | C | 6.0 | B | 3.9 | 43 | 95 |
| Comparative Example 8 | 45,200 | 32 | 45 | C | 0 | C | 5.9 | C | 3.7 | 40 | 95 |
| Comparative Example 9 | 51,300 | 22 | 70 | A | 38 | C | 4.3 | C | 2.1 | 50 | 94 |

(continued)

| | Film characteristics | | | | | | Film characteristics | | | | |
|---|---|---|---|---|---|---|---|---|---|---|---|
| | Weight average molecular weight | Terminal carboxyl group concentration (eq/ton) | Hydrolysis resistance Breaking elongation retention rate after 85°C 85%RH 3,000 hr (%) | | Hydrolysis resistance Breaking elongation retention rate after 85°C 85%RH 4,000 hr (%) | | Delamination strength (N/15 mm) | | | Heat resistance Breaking elongation retention rate after 130°C 6,000 hr (%) | Heat resistance Breaking elongation retention rate after xenon irradiation 200hr (%) |
| | | | | | | | Initial value | | After 85°C 85%RH 3,000 hr | | |
| Comparative Example 10 | 51,300 | 22 | 48 | C | 0 | C | specimen broken | A | specimen broken | 50 | 93 |

Comparative Example 1

The same procedures as in Example 1 were performed except that the kinds and the mixing ratios of the raw material were changed, thereby providing a polyester film having a thickness of 75 μm. The resulting film had the characteristics shown in Table 2. The film had a low weight average molecular weight, was inferior in hydrolysis resistance, delamination strength and heat resistance, and thus was not suitable for a rear surface protective film for a solar cell.

Comparative Example 1

The same procedures as in Example 1 were performed except that the mixing ratios of the raw material were changed, thereby providing a polyester film having a thickness of 75 μm. The resulting film had the characteristics shown in Table 2. The film had a low weight average molecular weight, was inferior in hydrolysis resistance, delamination strength and heat resistance due to the high titanium concentration, and thus was not suitable for a rear surface protective film for a solar cell.

Comparative Example 3

The same procedures as in Example 1 were performed except that the mixing ratios of the raw material were changed, thereby providing a polyester film having a thickness of 75 μm. The resulting film had the characteristics shown in Table 2. The film was good in hydrolysis resistance, delamination strength and heat resistance, but was inferior in weather resistance, and thus was not suitable for a rear surface protective film for a solar cell.

Comparative Example 4

The same procedures as in Example 1 were performed except that the kinds of the raw material were changed as shown in Table 1, thereby providing a polyester film having a thickness of 75 μm. The resulting film had the characteristics shown in Table 2. The film was inferior in weather resistance, and thus was not suitable for a rear surface protective film for a solar cell.

Example 4

The polyester raw materials of the layer (A) were mixed at the mixing ratios shown in Table 1 and dried in a rotation vacuum drier at 180°C for 3 hours, and the mixture was fed to an extruder 1 and melt-extruded at 285°C. For the layer (B), PET-b was dried in a rotation vacuum drier at 180°C for 3 hours, fed to an extruder 2 and melt-extruded at 285°C. The resin compositions thus melted in the extruders were joined together with a two-layer feed block, and formed into a sheet through a slit die while the laminated state thereof was maintained. The feeding amounts of the raw materials were controlled to make a thickness ratio of the layer (A) and the layer (B) of 20%/80%. The operations of from casting to heat setting were performed in the same manner as in Example 1, and after reducing the width by 4.0% in the transverse direction, both edges of the film were cut out, and the film was relaxed in the longitudinal direction at a relaxing ratio of 3.0% and then cooled to room temperature, thereby providing a polyester film having a thickness of 75 μm. The characteristics of the resulting films were as shown in Table 2. The delamination strength was measured after adhering the side of the layer (B) to a glass plate.

Comparative Example 5

The same procedures as in Example 4 were performed except that the raw material of the layer (B) was changed to PET-a, and the relaxing ratio in the longitudinal direction was 2.5%, thereby providing a polyester film having a thickness of 75 μm. The characteristics of the resulting films were as shown in Table 2. The delamination strength was measured after adhering the side of the layer (B) to a glass plate. The film had a low weight average molecular weight measured over the total film, was inferior in hydrolysis resistance, delamination strength and heat resistance, and thus was not suitable for a rear surface protective film for a solar cell.

Comparative Example 6

The same procedures as in Example 1 were performed except that the raw materials were changed as shown in Table 1, thereby providing a polyester film having a thickness of 75 μm. The characteristics of the resulting films were as shown in Table 2. The film was insufficient in crystallinity, was inferior in hydrolysis resistance, and thus was not suitable for a rear surface protective film for a solar cell.

Comparative Example 7

The same procedures as in Example 1 were performed except that the mixing ratios of the raw materials were changed as shown in Table 1, thereby providing a polyester film having a thickness of 75 μm. The characteristics of the resulting films were as shown in Table 2. The film was insufficient in crystallinity, was inferior in hydrolysis resistance, and thus was not suitable for a rear surface protective film for a solar cell.

Comparative Example 8

The same procedures as in Example 1 were performed except that the mixing ratios of the raw materials were changed as shown in Table 1, thereby providing a polyester film having a thickness of 75 μm. The characteristics of the resulting films were as shown in Table 2. The film was inferior in hydrolysis resistance and heat resistance although the reasons were not clear, and thus was not suitable for a rear surface protective film for a solar cell.

Comparative Example 9

The same procedures as in Example 1 were performed except that the heat set temperature was 200°C, thereby providing a polyester film having a thickness of 75 μm. The characteristics of the resulting films were as shown in Table 2. The film was good in hydrolysis resistance, but had problems including the low delamination strength and the like, and thus was not suitable for a rear surface protective film for a solar cell.

Comparative Example 10

The same procedures as in Example 1 were performed except that the heat set temperature was 245°C, thereby providing a polyester film having a thickness of 75 μm. The characteristics of the resulting films were as shown in Table 2. The film was inferior in hydrolysis resistance, and thus was not suitable for a rear surface protective film for a solar cell.

Examples 5 to 13

The polyester raw materials of the surface layer (A) and the substrate layer (B) shown in Table 3 were dried in separate rotation vacuum driers at 180°C for 3 hours, and the mixtures were fed to separate extruders and melt-extruded at 280°C, joined together with a three-layer feed block, and formed into a sheet through a slit die while the laminated state thereof was maintained. The thicknesses of the layers were controlled by the amounts of the raw materials fed to the extruders, and the ratio of layer (A)/layer (B)/layer (A) was controlled to those shown in Table 3. The sheet was cooled and solidified with a cooling drum having a surface temperature of 20°C to provide an unstretched film, which was stretched 3.4 times in the longitudinal direction (machine direction) at 100°C, and then cooled with rolls at 25°C. Subsequently, the film having been stretched in the machine direction was introduced into a tenter and stretched 3.7 times in the direction perpendicular to the longitudinal direction (transverse direction) in an atmosphere heated to 130°C while both ends of the film was held with clips. Thereafter, the film was heat-set for 15 seconds in an atmosphere heated to 222°C in the tenter for reducing the width by 4.0% in the transverse direction, both edges of the film were cut out, and the film was relaxed in the longitudinal direction at a relaxing ratio of 2.5% and then cooled to room temperature, thereby providing a laminate film having a thickness of 50 μm. The characteristics of the resulting films were as shown in Table 4.
Table 3

| | Film structure | | | | | | Contents in composition | | | | | |
|---|---|---|---|---|---|---|---|---|---|---|---|---|
| | Layer (A) | | Layer (B) | | Thickness ratio (%) (A)/(B)/(A) | Thickness (μm) | Catalyst metal element (millimole %) | | | Phosphoric acid compound | | Carbodiimide compound |
| | Composition | Titanium oxide amount (wt%) | Composition | Titanium oxide amount (wt%) | | | Mn | Sb | Ti | Kind | Content (millimole %) | Content (part by weight) |
| Example 5 | PET-a(100% by weight) | 0.0 | mixture of PET-a (83% by weight), PET-n (7% by weight) and PET-e (10% by weight) | 4.0 | 10/80/10 | 50 | 30 | 20 | 3 | phenylphosphonic acid | 15 | 1.1 |
| Example 6 | PET-b(100% by weight) | 0.0 | mixture of PET-b (83% by weight), PET-n (7% by weight) and PET-e (10% by weight) | 4.0 | 10/80/10 | 30 | 30 | 20 | 3 | phenylphosphonic acid | 15 | 1.1 |
| Example 7 | PET-b(100% by weight) | 0.0 | mixture of PET-b (87.5% by weight), PET-n (2.5% by weight) and PET-e (10% by weight) | 4.0 | 10/80/10 | 50 | 30 | 20 | 3 | phenylphosphonic acid | 15 | 0.4 |

(continued)

| | Film structure | | | | | | Contents in composition | | | | | |
|---|---|---|---|---|---|---|---|---|---|---|---|---|
| | Layer (A) | | Layer (B) | | Thickness ratio (%) (A)/(B)/(A) | Thickness (μm) | Catalyst metal element(millimole %) | | | Phosphoric acid compound | | Carbodiimide compound |
| | Composition | Titanium oxide amount (wt%) | Composition | Titanium oxide amount (wt%) | | | Mn | Sb | Ti | Kind | Content (millimole %) | Content (part by weight) |
| Example 8 | PET-a(100% by weight) | 0.0 | mixture of PET-b (75% by. weight), PET-n (15% by weight) and PET-e (10% by weight) | 4.0 | 5/90/5 | 100 | 30 | 20 | 3 | phenylphosphonic acid | 15 | 2.4 |
| Example 9 | mixture of PET-b (98% by weight) and PET-e (2% by weight) | 0.8 | mixture of PET-b (86% by weight), PET-n (4% by weight) and PET-e (10% by weight) | 4.0 | 10/80/10 | 50 | 30 | 20 | 3 | phenylphosphonic acid | 15 | 0.6 |
| Example 10 | mixture of PET-b (99.5% by weight) and PET-e (0.5% by weight) | 0.2 | mixture of PET-b (86% by weight), PET-n (4% by weight) and PET-e (10% by weight) | 4.0 | 10/80/10 | 30 | 30 | 20 | 3 | phenylphosphonic acid | 15 | 0.6 |

(continued)

| | Film structure | | | | | | Contents in composition | | | | | |
|---|---|---|---|---|---|---|---|---|---|---|---|---|
| | Layer (A) | | Layer (B) | | Thickness ratio (%) (A)/(B)/(A) | Thickness (μm) | Catalyst metal element (millimole %) | | | Phosphoric acid compound | | Carbodiimide compound |
| | Composition | Titanium oxide amount (wt%) | Composition | Titanium oxide amount (wt%) | | | Mn | Sb | Ti | Kind | Content (millimole %) | Content (part by weight) |
| Example 11 | mixture of PET-b (95.5% by weight) and PET-e (4.5% by weight) | 1.8 | mixture of PET-b (86% by weight), PET-n (4% by weight) and PET-e (10% by weight) | 4.0 | 10/80/10 | 150 | 30 | 20 | 3 | phenylphosphonic acid | 15 | 0.6 |
| Example 12 | PET-b(100% by weight) | 0.0 | mixture of PET-b (86% by weight), PET-n (4% by weight) and PET-e (10% by weight) | 4.0 | 10/80/10 | 25 | 30 | 20 | 3 | phenylphosphonic acid | 15 | 0.6 |
| Example 13 | PET-b(100% by weight) | 0.0 | mixture of PET-b (89.3% by weight), PET-n (0.7% by weight) and PET-e (10% by weight) | 4.0 | 40/20/40 | 50 | 30 | 20 | 3 | phenylphosphonic acid | 15 | 0.1 |

Table 4

| | Film characteristics | | | | | | Film characteristics | | | | |
|---|---|---|---|---|---|---|---|---|---|---|---|
| | | | | | | | Delamination strength (N/15 mm) | | | Heat resistance Breaking elongation retention rate after retention rate 130°C 6,000 hr (%) | Heat resistance Breaking elongation retention rate after xenon irradiation 200 hr (%) |
| | Weight average molecular weight | Terminal carboxyl group concentration (eq/ton) | Hydrolysis resistance Breaking elongation retention rate after 85°C 85%RH 3,000 hr (%) | | Hydrolysis resistance Breaking elongation retention rate after 85°C 85%RH 4,000 hr (%) | | Initial value | | After 85°C 85%RH 3,000 hr | | |
| Example 5 | 46,200 | 25 | 58 | B | 42 | B | 8.5 | A | 5.8 | 48 | 70 |
| Example 6 | 60,900 | 15 | 90 | A | 70 | A | 10.0 | A | 7.0 | 61 | 70 |
| Example 7 | 59,700 | 15 | 80 | A | 48 | B | 10.2 | A | 7.2 | 60 | 72 |
| Example 8 | 61,000 | 14 | 92 | A | 80 | A | 10.1 | A | 7.1 | 62 | 72 |
| Example 9 | 60,800 | 15 | 78 | A | 47 | B | 10.0 | A | 7.3 | 61 | 80 |
| Example 10 | 60,800 | 15 | 78 | A | 48 | B | 10.0 | A | 7.2 | 61 | 78 |
| Example 11 | 60,500 | 15 | 76 | A | 46 | B | 9.5 | A | 7.0 | 60 | 82 |
| Example 12 | 59,900 | 15 | 76 | A | 46 | B | 9.0 | A | 3.9 | 60 | 70 |
| Example 13 | 54,000 | 15 | 66 | B | 38 | C | 9.0 | A | 7.0 | 57 | 70 |

Industrial Applicability

The polyester film of the invention may be used as a white polyester film for protecting a rear surface of a solar cell, in that the polyester film is suppressed in reduction of mechanical properties on long-term use under a high temperature and high humidity environment, has excellent delamination resistance, and maintains a good protection function on long-term use.

## Claims

1. A polyester film for protecting a rear surface of a solar cell, the polyester film comprising a white polyester film layer containing a polyester composition containing 85 to 96% by weight of polyethylene terephthalate that is polymerized with an antimony compound and/or a titanium compound as a polycondensation catalyst and 4 to 15% by weight of rutile type titanium oxide particles, the polyester composition containing, based on the molar number of the total dicarboxylic acid component constituting the polyethylene terephthalate, 10 to 40 millimole % of a phosphoric acid compound represented by the following general formula (I) or (II):

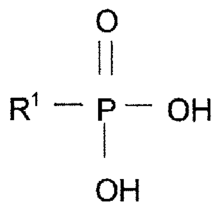

general formula (I)

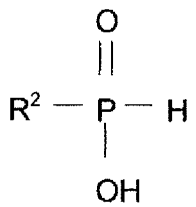

general formula (II)

(wherein $R^1$ and $R^2$ each represent one of an alkyl group which is a hydrocarbon group having 1 to 6 carbon atoms, an aryl group, and a benzyl group) and 2 to 50 millimole % in total in terms of metal elements of antimony element and/or titanium element derived from the polycondensation catalyst, and the polyester film for protecting a rear surface of a solar cell having an initial delamination strength of 6 N/15 mm or more and an elongation retention rate after aging for 3,000 hours under an environment with a temperature of 85°C and a humidity of 85%RH of 50% or more.

2. The polyester film for protecting a rear surface of a solar cell according to claim 1, wherein the film has an elongation retention rate after aging for 6,000 hours under an environment with a temperature of 130°C of 40% or more.

3. The polyester film for protecting a rear surface of a solar cell according to claim 1, wherein the film has a delamination strength after aging for 3,000 hours under an environment with a temperature of 85°C and a humidity of 85%RH of 4 N/15 mm or more.

4. The polyester film for protecting a rear surface of a solar cell according to claim 1, wherein the phosphoric acid compound is phenylphosphonic acid or phenylphosphinic acid.

5. The polyester film for protecting a rear surface of a solar cell according to claim 1, wherein the polyethylene terephthalate constituting the white polyester film layer has a terminal carboxyl group concentration of 6 to 20 eq/ton.

6. The polyester film for protecting a rear surface of a solar cell according to claim 1, wherein the polyethylene terephthalate constituting the white polyester film layer has a weight average molecular weight of 44,000 to 61,000.

7. The polyester film for protecting a rear surface of a solar cell according to claim 1, wherein the polyester film is a stretched film having a laminated structure containing a substrate layer having provided on at least one surface thereof a surface layer, and at least one layer thereof is the white polyester film layer.

**8.** The polyester film for protecting a rear surface of a solar cell according to claim 7, wherein the polyester film is a stretched film having a laminated structure containing a substrate layer having provided on both surfaces thereof surface layers, at least one layer thereof is the white polyester film layer, the surface layers are each a layer having a thickness of 3.0 μm or more and containing polyethylene terephthalate containing no carbodiimide compound, the substrate layer contains 0.3 to 2.5 parts by weight of a carbodiimide compound per 100 parts by weight of the polyethylene terephthalate, and the polyester film has an elongation retention rate after aging for 4,000 hours under an environment with a temperature of 85°C and a humidity of 85%RH of 40% or more.

**9.** A protective film for a rear surface of a solar cell, comprising the polyester film for protecting a rear surface of a solar cell according to any one of claims 1 to 8.

**INTERNATIONAL SEARCH REPORT**

International application No.
PCT/JP2011/058517

A. CLASSIFICATION OF SUBJECT MATTER
*H01L31/042*(2006.01)i, *C08G63/85*(2006.01)i, *C08J5/18*(2006.01)n

According to International Patent Classification (IPC) or to both national classification and IPC

B. FIELDS SEARCHED

Minimum documentation searched (classification system followed by classification symbols)
H01L31/042, C08G63/85, C08J5/18

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2010-064250 A (Toray Industries, Inc.), 25 March 2010 (25.03.2010), entire text (Family: none) | 1-9 |
| A | JP 2007-129204 A (Toray Industries, Inc.), 24 May 2007 (24.05.2007), entire text (Family: none) | 1-9 |
| A | JP 2010-031139 A (Teijin Ltd.), 12 February 2010 (12.02.2010), entire text (Family: none) | 1-9 |

[X] Further documents are listed in the continuation of Box C. [ ] See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 22 April, 2011 (22.04.11) | 10 May, 2011 (10.05.11) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.
PCT/JP2011/058517

C (Continuation). DOCUMENTS CONSIDERED TO BE RELEVANT

| Category* | Citation of document, with indication, where appropriate, of the relevant passages | Relevant to claim No. |
|---|---|---|
| A | JP 2004-175911 A (Teijin Ltd.), 24 June 2004 (24.06.2004), entire text (Family: none) | 1-9 |
| A | JP 2010-121065 A (Teijin Fibers Ltd.), 03 June 2010 (03.06.2010), entire text (Family: none) | 1-9 |
| P,A | WO 2010/113920 A1 (Teijin DuPont Films Japan Ltd.), 07 October 2010 (07.10.2010), entire text (Family: none) | 1-9 |
| P,A | WO 2010/110119 A1 (Toray Industries, Inc.), 30 September 2010 (30.09.2010), entire text (Family: none) | 1-9 |
| P,A | JP 2010-254779 A (Teijin DuPont Films Japan Ltd.), 11 November 2010 (11.11.2010), entire text (Family: none) | 1-9 |
| P,A | WO 2010/123087 A1 (Teijin DuPont Films Japan Ltd.), 28 October 2010 (28.10.2010), entire text (Family: none) | 1-9 |
| P,A | JP 2010-254805 A (Teijin Ltd.), 11 November 2010 (11.11.2010), entire text (Family: none) | 1-9 |
| P,A | WO 2010/079798 A1 (Toyobo Co., Ltd.), 15 July 2010 (15.07.2010), entire text & JP 2010-161138 A & JP 2010-158828 A | 1-9 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2007129014 A
- JP 2007070885 A
- JP 2006306910 A
- JP 2002026354 A
- WO 07105306 A
- JP 2002100788 A
- JP 2002 A
- JP 134770 A
- JP 2002134771 A
- JP 2006270025 A
- WO 0710530 A
- JP 2002134770 A
- JP 57057628 A